# EUROPÄISCHE PATENTSCHRIFT

(11) **EP 0 663 726 B1**
(45) Veröffentlichungstag und Bekanntmachung des Hinweises auf die Patenterteilung: **09.06.1999**
(21) Anmeldenummer: 95200026.3
(22) Anmeldetag: 09.01.1995
(51) Int. Cl.: H03K 19/00, H03K 19/003, H03K 19/017

(54) **Ausgangstreiberschaltung**
Output driver circuit
Circuit d'attaque de sortie

(30) Priorität: 14.01.1994 DE 4400872
(43) Veröffentlichungstag der Anmeldung: 19.07.1995
(73) Patentinhaber: Philips Patentverwaltung GmbH, 22335 Hamburg (DE); Koninklijke Philips Electronics N.V., 5621 BA Eindhoven (NL)
(72) Erfinder: Koke, Andreas, c/o Philips Patentverwaltung GmbH, D-20097 Hamburg (DE)
(74) Vertreter: Peters, Carl Heinrich, Dipl.-Ing.

(56) Entgegenhaltungen:
- EP-A- 0 250 036
- EP-A- 0 297 932
- EP-A- 0 439 407
- US-A- 4 622 482
- PATENT ABSTRACTS OF JAPAN vol. 015 no. 102 (E-1043) ,12.März 1991 & JP-A-02 309810 (SEIKO EPSON CORP.) 25.Dezember 1990,
- PATENT ABSTRACTS OF JAPAN vol. 015 no. 102 (E-1043) ,12.März 1991 & JP-A-02 309809 (SEIKO EPSON CORP.) 25.Dezember 1990,

## Beschreibung

Die vorliegende Erfindung bezieht sich auf eine Ausgangstreiberschaltung, in der die Erzeugung von elektromagnetischen Störstrahlungen bei hoher Schaltgeschwindigkeit wesentlich verringert wird. Die Schaltung enthält zwei Kondensatoren, die zwischen dem Ausgangsknoten und den Gates der Ausgangstransistoren in Gegenkopplung geschaltet sind, wodurch die Flankensteilheit des Ausgangssignals verringert wird. Der Stand der Technik gibt verschiedene Lösungen zu den Problemen an, die bei hoher Schaltgeschwindigkeit in Ausgangsschaltungen auftauchen.

In der EP-A-0368524 wird eine Ausgangstreiberschaltung beschrieben, wobei auch Kondensatoren zwischen dem Ausgang und den Gates der Ausgangstransistoren geschaltet sind, um die Schaltgeschwindigkeit der Ausgangstransistoren zu vermindern und damit die Spannungsspitze in der Versorgungsspannung und in der Masseleitung zu verringern.

In der EP-A-0379881 wird eine Ausgangstreiberschaltung beschrieben, wobei ein einziger Kondensator zwischen dem Ausgangsknoten und dem Gate eines unteren Ausgangstransistors geschaltet ist, um die Spannung am Gate dieses Ausgangstransistors in einer bestimmten Weise formen zu können.

In der US-4622482 wird eine Schaltung angegeben in der u.a. auch die Ausstrahlung hochfrequenter Signale vermieden werden soll. Dazu wird die Flankensteilheit reduziert, wobei hier ein Miller-Integrator verwendet wird. Der Anstieg der Flanke kann somit über die Kapazität der verwendeten Kondensatoren und einen einstellbaren Strom durch gesteuerte Transistoren beeinflußt werden.

Im ersten der obengenannten Dokumente dienen die Kondensatoren, in Kombination mit den zwei Widerständen und dem Inverter, die sich im Pfad des Eingangssignals befinden, dazu, die Steilheit der Ausgangssignalübergänge zu verringern. Diese Maßnahmen verursachen eine unzulässig lange Verzögerung, überdies können die Ausgangssignalflanken nicht gut definiert werden. Die Schaltung im zweiten Dokument leidet auch unter einer zu langen Verzögerung, obwohl hier die Ausgangssignalflanken sich durch den Betrieb des unteren Transistors mit einer Betriebsspannung, die sich mit der Quadratwurzel der Zeit ändert, mit höheren Genauigkeit gestalten läßt. Auch im dritten Dokument wird für die Verringerung der Flankensteilheit, durch das rampenartige Ansteuersignal für die Ausgangstransistoren, eine Verlängerung der Schaltzeit in Kauf genommen.

Keines der Dokumente des Standes der Technik zeigt die Merkmale einer gut definierten steuerbaren Flankensteilheit in Kombination mit Beschleunigungsschaltungen, um den Anfang des Überganges zu beschleunigen.

In der DE 42 06 864 ist eine Ausgangstreiberschaltung beschrieben, die ohne Verwendung von Kondensatoren eine geringere Flankensteilheit des Ausgangssignals erreichen soll. Diese Schaltung sieht für jeden Ausgangstransistor eine Treiberschaltung vor, die einen Inverter und eine mit dem Inverter verbundene Verzögerungsschaltung enthält. Bei einem Signalwechsel am Eingang, der den Ausgangstransistor einschalten soll, wird das Gate des Ausgangstransistors über den niederohmigen Inverter schnell umgeladen, bis der Ausgangstransistor beginnt. leitend zu werden. In diesem Augenblick soll der Inverter durch die Verzögerungsschaltung hochohmig geschaltet werden, so daß das Gate des Ausgangstransistors nur noch langsam seinen Pegel ändert und der Ausgangstransistor langsam einschaltet. Dafür ist jedoch eine genaue Einstellung verschiedener Parameter einschließlich der Verzögerungszeit der Verzögerungsschaltung erforderlich, die nur sehr schwer erreichbar ist.

In der EP-A-0439407 wird eine Treiberschaltung beschrieben, die eine schnellere Umschaltung des Ausgangssignals mit gleichzeitiger Reduzierung der Störspannungen ermöglicht. Dazu werden zwei Ausgangstransistoren während der Umschaltphase zusätzlich durch zwei Treibertransistoren aufgeladen. Diese Transistoren sind jeweils mit den Gates der Ausgangstransistoren verbunden und werden bei Erreichen ihrer eigenen Schwellspannung abgeschaltet, wodurch der Umschaltprozeß danach wieder mit normaler Geschwindigkeit abläuft. Hier wird durch Treibertransistoren eine Beschleunigung des Umschaltvorgangs vorgenommen. Da die Treibertransistoren nach Erreichen ihrer eigenen Schwellspannung abgeschaltet werden, ist keine direkte Kopplung mit der Dauer des Ladevorgangs der Ausgangstransistoren erfolgt. Durch diese Beschleunigung wird eine Störspannung erzeugt. Nach dem Abschalten der Treibertransistoren werden die Ausgangstransistoren weiter geladen, wobei hier keine zusätzliche Reduzierung der Flankensteilheit vorgenommen wird.

In der JP-2309810 ist eine Schaltung angegeben, mit der Störungen reduziert werden sollen, ohne das Umschalten zeitlich zu verzögern. Mit einer Stromquelle wird ein Ausgangstransistor geladen, der zusätzlich auch noch mit einer zweiten Stromquelle geladen wird. Dadurch erhöht sich die Ladung am Gate des Ausgangstransistors sehr schnell. Die zweite Stromquelle wird durch einen Verzögerungsinverter abgeschaltet. Auch in dieser Schaltung ist das Abschalten der zweiten Stromquelle zur Beschleunigung des Ladevorgangs des Ausgangstransistors nicht an die Schwellspannung des Ausgangstransistors gekoppelt.

Aufgabe der Erfindung ist, eine Schaltung anzugeben, die die Ausstrahlung von unerwünschten hochfrequenten Signalen vermeidet, ohne unzulässige lange Verzögerungen zu verursachen.

Diese Aufgabe wird durch die Merkmale des Anspruchs 1 gelöst. Dadurch wird erreicht, daß die Spannungen an den Gates der Ausgangstransistoren sehr schnell von den Beschleunigungsschaltungen, die einen großen Strom den Gates der Ausgangstransistoren liefern, zu ihren Spannungsschwellen gebracht werden. Sobald die Spannungsschwellen erreicht werden, werden diese Beschleunigungsschaltungen ausgeschaltet, um den Übergang des Ausgangssignals von der Kondensatorumladung bestimmen zu lassen, indem den Gates jetzt jeweils ein kleiner Strom von den weiteren Stromquellen zugeführt wird. Vorteilhaft ist die Genauigkeit, mit der die Ausgangssignalflanken und deren Beginn definiert werden können, denn bei Erreichen der Schwellspannung wird die Beschleunigungsschaltung abgeschaltet. Über die Kapazität der Kondensatoren und den Strom der Stromsteuerschaltung wird die Flankensteilheit des Ausgangssignals gesteuert.

Ausgestaltungen der Erfindung sind in den abhängigen Ansprüchen gekennzeichnet.

Ausführungsbeispiele der Erfindung werden nachfolgend anhand der Zeichnung näher erläutert. Es zeigen:
Fig. 1 ein Blockschaltbild einer erfindungsgemäßen Ausgangstreiberschaltung,
Fig. 2 ein detailliertes Schaltbild.

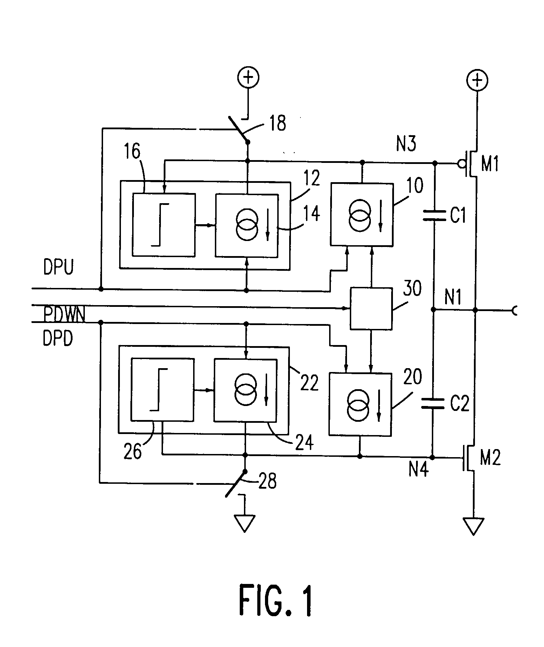

In Fig. 1 sind zwei komplementäre MOS Ausgangstranistoren M1 und M2 in Reihe zwischen der positiven Versorgungsspannung und Masse angeordnet, wobei ein Ausgangsknoten N1 in dem Kopplungspunkt zwischen beiden Ausgangstransistoren entsteht, der mit einem Ausgangsanschluß verbunden ist. Das Gate des Ausgangstransistors M1 ist mit einem Kopplungspunkt N3 verbunden, der weiter mit einer Anzahl Elementen verbunden ist, nämlich mit einem Kondensator C1, einer ersten Stromquelle 10, einer ersten Beschleunigungsschaltung 12 und einem Schalter 18. Entsprechend ist das Gate des Ausgangstransistors M2 mit einem Knotenpunkt N4 verbunden, der ferner mit einem Kondensator C2, einer zweiten Stromquelle 20, einer zweiten Beschleunigungsschaltung 22 und einem weiteren Schalter 28 verbunden ist. Die Kondensatoren C1 und C2 sind mit dem Ausgangsknoten N1 verbunden. Dadurch stellt der Ausgangstransistor M1 zusammen mit dem Kondensator C1 einen Miller-Integrator dar, wenn dem Knotenpunkt N3 ein konstanter Strom zugeführt wird. Entsprechend stellt auch der Ausgangstransistor M2 mit dem Kondensator C2 einen Miller-Integrator dar.

Die dargestellte Ausgangstreiberschaltung wird über zwei getrennte Eingänge DPU und DPD angesteuert. Die weitere Beschreibung der Funktion der Ausgangstreiberschaltung wird auf den ersten Ausgangstransistor M1 mit den zugehörigen Elementen beschränkt, da der Ausgangstransistor M2 und die zu diesem gehörigen Elemente entsprechend spiegelbildlich arbeiten. Es wird nur bemerkt, daß die beiden Eingangssignale gleichen Signalpegel haben müssen.

Das Signal am Eingang DPU steuert den Schalter 18 sowie die Beschleunigungsschaltung 12 und die Stromquelle 10 an. Wenn das Signal an DPU hoch ist, ist der Schalter 18 geschlossen, so daß der Knotenpunkt N3 die positive Versorgungsspannung führt und den Ausgangstransistor M1 vollständig abschaltet, während die Beschleunigungsschaltung 12 und die Stromquelle 10 abgeschaltet sind.

Wenn nun das Signal an DPU niedrig wird, wird der Schalter 18 geöffnet, und gleichzeitig werden die Stromquelle 10 und die Beschleunigungsschaltung 12 eingeschaltet. Der Strom der Stromquelle 10 wird durch eine Stromsteuerschaltung 30 auf einen Wert eingestellt, der zusammen mit dem Wert des Kondensators C1 die gewünschte Ausgangsflanke am Ausgangsknoten N1 erzeugt.

Die Beschleunigungsschaltung 12 enthält eine weitere Stromquelle 14, die dem Knotenpunkt N3 einen hohen Strom zuführt. Dadurch wird nach dem Übergang des Signals an DPU der Knotenpunkt N3 sehr schnell negativer, bis er einen Wert erreicht, bei dem eine Schwellwertschaltung 16 in der Beschleunigungsschaltung 12 anspricht und die Stromquelle 14 abschaltet. Der Schwellwert der Schwellwertschaltung 16 ist vorzugsweise etwa gleich der Schwellspannung, bei der der Ausgangstransistor M1 zu leiten beginnt. Dadurch wird die Spannung des Knotenpunkts N3 nach einem Signalübergang des Signals an DPU schnell auf einen Wert gebracht, bei der der Ausgangstransistor M1 zu leiten beginnt. Danach fließt jedoch nur noch der geringe Strom der Stromquelle 10, so daß nun die Spannung am Ausgangsknoten N1 in gewünschter Weise definiert ansteigt, und zwar zeitlich linear, wenn die Stromquelle 10 einen konstanten Strom liefert. Dieser lineare Anstieg setzt also mit nur geringer Verzögerung nach einem Signalwechsel des Signals DPU ein.

Über den Eingang PDWN kann die Stromsteuerschaltung 30 so angesteuert werden, daß sie die Stromquelle 10 und entsprechend die Stromquelle 20 auf einen hohen Strom umschaltet. Dadurch entsteht dann auf dem Ausgangsknoten ein steiler Signalübergang N1, was in bestimmten Fällen günstiger sein kann.

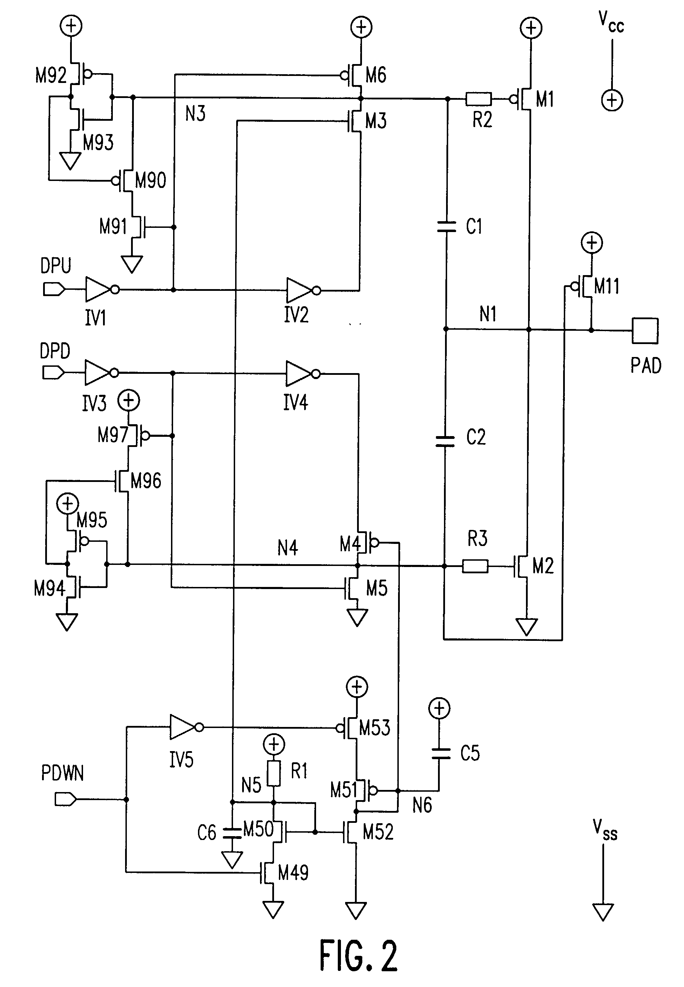

Das Schaltbild in Fig. 2 zeigt eine Möglichkeit für den genauen Aufbau der Stromquellen 10 bzw. 20 und der Beschleunigungsschaltungen 12 bzw. 22. Nachfolgend wird wiederum nur der obere Teil der Ausgangstreiberschaltung beschrieben, da der andere Schaltungsteil mit dem unteren Ausgangstransistor entsprechend spiegelbildlich arbeitet.

In der Beschleunigungsschaltung ist die Reihenschaltung der Transistoren M90 und M91 mit dem Eingang des Inverters M92, M93 und dem Gate des oberen Ausgangstransistors M1 in einem Kopplungspunkt N3 gekoppelt. Einer der in Reihe geschalteten Transistoren ist ein NMOS Transistor M91, der mit der unteren Versorgungsspannung Vss, d.h. mit Masse gekoppelt ist und dessen Gate das Signal am Eingang DPU über einen Inverter IV1 zugeführt wird. Der zweite Transistor der Reihenschaltung ist ein PMOS Transistor M90, der zwischen dem Transistor M91 und Kopplungspunkt N3 angeordnet ist und dessen Gate mit dem Ausgang des Inverters M92, M93 gekoppelt ist. Ein weiterer PMOS Transistor M6 ist zwischen der oberen Versorgungsspannung und dem Kopplungspunkt N3 angeordnet, und ein anderer NMOS Transistor M3 ist mit dem Kopplungspunkt N3 gekoppelt. Ein Widerstand R2 ist zwischen dem Kopplungspunkt N3 und dem Gate des oberen Ausgangstransistors M1 eingefügt, um zu verhindern, daß ein auf den Ausgang eingestreuter Impuls einen Spannungsdurchschlag in der Gate-Drain-Strecke des Ausgangstransistors M1 verursacht. Zwischen dem Kopplungspunkt N3 und dem Ausgangsknoten N1 ist der Kondensator C1 angeordnet.

Der Eingang DPU wird über einen Inverter IV1 mit den Gates des NMOS Transistors M91 und des PMOS Transistors M6 und über einen weiteren Inverter IV2 mit der Source des NMOS Transistor M3 gekoppelt. Ein mittlerer Spannungspegel wird dem Gate des NMOS Transistor M3 von einer Stromspiegelschaltung, die später beschrieben wird, zugeführt.

Zunächst wird angenommen, daß das Signal am Eingang DPU sich auf einem hohen logischen Pegel befindet, der vom Inverter IV1 invertiert wird, wobei der NMOS Transistor M91 gesperrt wird und der PMOS Transistor M6 leitend wird. Da der NMOS Transistor M91 gesperrt ist, kann kein Strom aus dem Kopplungspunkt N3 nach Masse fließen, und weil die Versorgungsspannung Vcc über den PMOS Transistor M6 dem Kopplungspunkt N3 gekoppelt ist, wird der erste Ausgangstransistor M1 gesperrt. Weil der Inverter IV2 einen hohen Spannungspegel dem NMOS Transistor M3 zuführt, kann kein Strom aus dem Kopplungspunkt N3 über diesen Pfad nach Masse fließen. Da der Kopplungspunkt N3 eine Spannung annimmt, die gleich der oberen Versorgungsspannug Vcc ist, wird ein niedriger Spannungspegel dem Gate des PMOS Transistor M90 über den Inverter M92,M93 zugeführt, wobei der PMOS Transistor M90 leitend wird.

Wenn das Signal am Eingang DPU von dem höheren Pegel zu einem niedrigen Pegel übergeht, nimmt der Ausgang des Inverters IV1 einen hohen Spannungspegel an, wobei der NMOS Transistor M91 leitend und der PMOS Transistor M6 gesperrt wird; über den NMOS Transistor M3 wird vom Inverter IV2 ein hochohmiger Pfad nach Masse freigegeben. Da ein Strom aus dem Kopplungspunkt N3 fließt, wird die Spannung am Gate des Ausgangstransistor M1 abnehmen. Dieser Strom verteilt sich auf zwei Zweige: Ein erster großer Strom, der über die Reihenschaltung der zwei komplementären Transistoren M90,M91, und ein zweiter Strom, der durch den NMOS Transistor M3 nach Masse fließt. Der erste große Strom fließt, bis der Spannungspegel im Kopplungspunkt N3 die Schwellspannung des PMOS Transistor M92 erreicht, wobei der Ausgang des Inverters umschalten wird und der PMOS Transistor M90 gesperrt wird. Dabei wird angenommen, daß der NMOS Transistor M93 hochohmig ist, und außerdem, daß die Schwellspannung des PMOS Transistors M92 etwas größer ist als die des Ausgangstransistors M1, da die Spannung an dessen Gate durch den Widerstand R2 und die Drain-Gate-Kapazität des Ausgangstransistors M1 der Spannung des Kopplungspunktes N3 etwas nacheilt. Bei gegebenen Werten dieser Elemente kann die Schwellspannung des PMOS-Transistors M92 so gewählt werden, daß das Ausgangssignal des Inverters gerade zu dem Zeitpunkt umschaltet und den PMOS Transistor M90 sperrt, wenn die Spannung direkt am Gate des Ausgangstransistors M1 die Schwellspannung erreicht hat. Damit wird die Wirkung der Beschleunigungsschaltung beendet, wenn die Spannung am Gate des Ausgangstransistors M1 schnell bis zur Schwellspannung gebracht worden ist.

Der einzige Strom, der aus dem Kopplungspunkt N3 jetzt fließt, wird durch NMOS Transistor M3 abgeleitet. Die Spannung am Ausgangsknoten nimmt langsam zu; gleichzeitig nimmt die Spannung am Gate des Ausgangstransistor M1 ab. Die zunehmende Ausgangsspannung wird vom Kondensator C1 zum Kopplungspunkt N3 gekoppelt, wobei eine zu rasche Abnahme der Spannung am Gate des ersten Ausgangstransistors M1 ausgeglichen wird, um dadurch eine Ausgangssignal mit definierter Flankensteilheit zu erreichen, und zwar als eine lineare Funktion der Zeit.

Das hier unterliegende Prinzip ist das des Miller-Integrators. Wenn eine Sprungfunktion einem Miller-Integrator als Eingangssignal zugeführt wird, bekommt man eine Funktion am Ausgang, die linear von der Zeit abhängt. Da die Flankensteilheit des Ausgangssignal begrenzt wird, wird die Ausstrahlung von hochfrequenten Störungen wesentlich verringert.

Die Transistoren M49 bis M53 bilden die Stromspiegelschaltung. Diese weist eine erste zwischen der oberen Versorgungsspannung Vcc und Masse geschaltete Reihenschaltung auf, die aus einem Widerstand R1 und zwei NMOS Transistoren M49 und M50 besteht, wobei der Widerstand R1 und die Source des NMOS Transistors M49 mit der oberen Versorgungsspannung Vcc bzw. mit Masse gekoppelt sind und der NMOS Transistor M50 mit dem Widerstand R1 in einem ersten Ausgangsknoten N5 der Stromspiegelschaltung und mit der Drain des NMOS Transistors M49 gekoppelt ist. Das Gate des Transistors M50 ist mit dem Kopplungspunkt N5 verbunden.

Die Stromspiegelschaltung weist eine zweite zwischen der oberen Versorgungsspannung Vcc und Masse geschaltete Reihenschaltung auf, die aus zwei PMOS Transistoren M53 und M51 und einem NMOS Transistor M52 besteht, wobei die Source des PMOS Transistors M53 und die Source des NMOS Transistors M52 mit der oberen Versorgungsspannung Vcc bzw. mit der Masse verbunden sind und der PMOS Transistor M51 mit dem PMOS Transistor M53 und in einem zweiten Ausgangsknoten N6 der Stromspiegelschaltung mit der Drain des NMOS Transistors M52 verbunden ist. Das Gate des PMOS Transistors M51 ist mit dem Kopplungspunkt N6 verbunden. Das Gate des NMOS Transistors M50 ist mit dem Gate des Transistors M52 verbunden.

Die Kopplungspunkte N5 und N6 sind mit dem Gate des NMOS Transistors M3 bzw. mit dem Gate des PMOS Transistors M4 verbunden. Die Stromspiegelschaltung wird vom Eingangssignal PDWN angesteuert, welches direkt dem Gate des NMOS Transistors M49 und über einen Inverter IV5 dem Gate des PMOS Transistors M53 zugeführt wird.

Ein erster Strom, der durch den Widerstand R1 und die NMOS Transistoren M49,M50 fließt, wird in einen zweiten Strom gespiegelt, der durch die Transistoren M51-M53 fließt.

Wenn das Signal am Eingang PDWN einen hohen logischen Pegel annimmt, wird die Stromspiegelschaltung wirksam. Dabei werden die Leitfähigkeiten der Transistoren M3 und M4 durch die Spannungen, die an den Kopplungspunkten N5 und N6 entstehen, gesteuert und damit der Strom, den diese Transistoren vom Knoten N3 bzw. N4 ableiten. Über die Kapazität der Kondensatoren C1 und C2 wird dadurch die Flankensteilheit des Ausgangssignals bestimmt. Die Aufgabe der Kondensatoren C5,C6 ist nur, Schwankungen in der Spannungsversorgung Vcc und in der Masseleitung von den Gates des NMOS Transistors M3 und des PMOS Transistors M4 zu entkoppeln.

Wenn das Signal am Eingang PDWN einen niedrigen logischen Pegel annimt, wird die Stromspiegelschaltung nicht wirksam, wobei die Gates der Transistoren M4 und M3 mit Masse bzw. der oberen Versorgungsspannung gekoppelt werden und die Transistoren gesättigt leiten. Dann wird die Flankensteilheit des Ausgangssignal nicht mehr kontrollierbar. Durch die Ausschaltung des Stromspiegelschaltung kann Leistung eingespart werden, was bei batteriebetriebenen Anwendungen sehr wichtig ist.

Ferner besitzt die Ausgangstreiberschaltung nach der Erfindung die Fähigkeit, als Tri-State zu arbeiten. Wenn das Signal am Eingang DPU einen hohen und das Signal am Eingang DPD einen niedrigen logischen Pegel annehmen, werden beide Ausgangstransistoren M2,M1 gesperrt, wobei ein kleiner schwacher PMOS Transistor M11 leitend wird, der zwischen der Versorgungsspannung Vcc und dem Ausgangsknoten angeordnet ist. Dieser PMOS Transistor M11 ist hochohmig hergestellt, so daß ein extern angelegtes niedriges logisches Signal das Potential am Ausgangsknoten ohne weiteres herunterziehen kann und dieser Ausgangsknoten in diesem Zustand als Eingang verwendet werden kann.

## Patentansprüche

1. Ausgangstreiberschaltung mit einem ersten Ausgangstransistor (M1) zwischen einer ersten oberen Versorgungsspannung (Vcc) und einem Ausgangsknoten (N1), einem zweiten Ausgangstransistor (M2) zwischen dem Ausgangsknoten (N1) und einer unteren Versorgungsspannung (Vss), einem ersten Kondensator (C1) zwischen dem Gate des ersten Ausgangstransistor (M1) und dem Ausgangsknoten (N1), einem zweiten Kondensator (C2) zwischen dem Ausgangsknoten (N1) und dem Gate des zweiten Ausgangstransistor (M2), einer ersten Stromquelle (10), die mit dem ersten Kondensator (C2) und dem Gate des ersten Ausgangstransistors in einem ersten Kopplungspunkt (N3) verbunden ist zum Liefern eines ersten Stromes zum ersten Kopplungspunkt (N3), einer zweiten Stromquelle (20), die mit dem zweiten Kondensator (C1) und dem Gate des zweiten Ausgangstransistor (M2) in einem zweiten Kopplungspunkt (N4) verbunden ist zum Liefern eines zweiten Stromes zum zweiten Kopplungspunkt (N4), dadurch gekennzeichnet, daß eine erste Beschleunigungsschaltung (12), deren Eingang und Ausgang mit dem ersten Kopplungspunkt (N3) gekoppelt sind, und eine zweite Beschleunigungsschaltung (22), deren Eingang und Ausgang mit dem zweiten Kopplungspunkt (N4) gekoppelt sind, so gesteuert sind, daß sie bei Erreichen der Schwellspannung der Ausgangstransistoren (M1,M2) einen von den Beschleunigungsschaltungen erzeugten Strom, der wesentlich höher ist als der erste beziehungsweise zweite Strom, zur schnelleren Aufladung der Kondensatoren (C1,C2) beim Einschalten der Ausgangstransistoren (M1,M2) gezielt durch jeweils einen Schwellwertschalter (16,26), der im wesentlichen die gleiche Schwellspannung wie der zugehörige Ausgangstransistor hat, abschalten.

2. Ausgangstreiberschaltung nach Anspruch 1,
dadurch gekennzeichnet, daß die erste Stromquelle einen ersten NMOS Transistor (M3) und die zweite Stromquelle einen ersten PMOS Transistor (M4) enthält, wobei die Gates beider Transistoren mit Steuermitteln zum Steuern der Leitfähigkeit beider Transistoren in gleichem Ausmaß verbunden sind.

3. Ausgangstreiberschaltung nach Anspruch 1,
dadurch gekennzeichnet, daß die erste Beschleunigungsschaltung (12) einen zweiten PMOS (M92) und eine erste, aus einem dritten PMOS Transistor (M90) und einem zweiten NMOS Transistor (M91) bestehende Reihenschaltung enthält, und die zweite Beschleunigungsschaltung (22) einen dritten NMOS Transistor (M94) und eine zweite aus einem vierten PMOS Transistor (M97) und einem vierten NMOS Transistor (M96) bestehende Reihenschaltung enthält, daß die erste Reihenschaltung zwischen dem ersten Kopplungspunkt (N3) und der unteren Versorgungsspannung (Vss) angeordnet ist, wobei das Gate des dritten PMOS Transistors (M90) mit dem zweiten PMOS Transistor (M92) verbunden ist und ein erster Eingang (DPU) mit dem Gate des zweiten NMOS Transistors (M91) gekoppelt ist, daß die zweite Reihenschaltung zwischen der oberen Versorgungsspannung (Vcc) und dem zweiten Kopplungspunkt (N4) angeordnet ist, wobei das Gate des vierten NMOS Transistor (M96) mit dem dritten NMOS Transistor (M94) verbunden ist und ein zweiter Eingang (DPD) mit dem Gate des vierten PMOS Transistor (M97) gekoppelt ist, und daß die Schwellspannungen des ersten Ausgangstransistors (M1) und des zweiten PMOS Transistors (M92) sowie des zweiten Ausgangstransistors (M2) und des dritten NMOS Transistors (M94) im wesentlichen gleich sind.

4. Ausgangstreiberschaltung nach Anspruch 3,
dadurch gekennzeichnet, daß ein fünfter PMOS Transistor (M6) zwischen der oberen Versorgungsspannung (Vcc) und dem ersten Kopplungspunkt (N3) und ein fünfter NMOS Transistor (M5) zwischen dem zweiten Kopplungspunkt (N4) und der unteren Versorgungsspannung (Vss) geschaltet sind, daß der erste Eingang (DPU) ferner dem Gate des fünften PMOS Transistors (M6), und der zweite Eingang (DPD) ferner mit dem Gate des fünften NMOS Transistors (M5) gekoppelt ist.

5. Ausgangstreiberschaltung nach Anspruch 2 und 3,
dadurch gekennzeichnet, daß der erste Eingang (DPU) über einen ersten Inverter (IV2) mit dem ersten NMOS Transistor (M3) und das zweite Eingangssignal (DPD) über einen zweiten Inverter (IV4) mit dem ersten PMOS Transistor (M4) gekoppelt ist.

6. Ausgangstreiberschaltung nach einem der Ansprüche 2 bis 5,
dadurch gekennzeichnet, daß die Leitfähigkeit des ersten NMOS Transistors (M3) und des ersten PMOS Transistors (M4) über einen dritten Eingang (PDWN) steuerbar ist.

7. Ausgangstreiberschaltung nach einem der Ansprüche 2 bis 6,
dadurch gekennzeichnet, daß ein erster Ausgang einer Stromspiegelschaltung (R1, M49-M53) mit dem Gate des ersten NMOS Transistors (M3) und ein zweiter Ausgang der Stromspiegelschaltung mit dem Gate des ersten PMOS Transistors (M4) verbunden sind.

8. Ausgangstreiberschaltung nach Anspruch 6 und 7,
dadurch gekennzeichnet, daß, wenn sich das dritte Eingangssignal (PDWN) in einem ersten logischen Zustand befindet, der erste NMOS Transistor (M3) und der erste PMOS Transistor (M4) gesättigt leitend werden, und wenn sich das dritte Eingangssignal (PDWN) in einem zweiten logischen Zustand befindet, die Leitfähigkeit des ersten NMOS (M3) und des ersten PMOS (M4) von der Stromspiegelschaltung bestimmt wird.

## Claims

1. An output driver circuit, comprising a first output transistor (M1) which is connected between a first, upper supply voltage (Vcc) and an output node (N1), a second output transistor (M2) which is connected between the output node (N1) and a lower supply voltage (Vss), a first capacitor (C1) which is connected between the gate of the first transistor (M1) and the output node (N1), a second capacitor (C2) which is connected between the output node (N1) and the gate of the second output transistor (M2), a first current source (10) which is connected to the first capacitor (C2) and the gate of the first output transistor in a first node (N3) in order to apply a first current to the first node (N3), a second current source (20) which is connected to the second capacitor (C1) and the gate of the second output transistor (M2) in a second node (N4) in order to apply a second current to the second node (N4), characterized in that a first acceleration circuit (12), whose input and output are coupled to the first node (N3), and a second acceleration circuit (22), whose input and output are coupled to the second node (N4), are controlled in such a manner that, when the threshold voltage of the output transistors (M1, M2) is reached, they deliberately switch off a current which is generated by the acceleration voltage and is substantially larger than the first or the second current in order to achieve faster charging of the capacitors (C1, C2) when the output transistors (M1, M2) are turned on, using a respective threshold value switch (16, 26) having essentially the same threshold voltage as the associated output transistor.

2. An output driver as claimed in Claim 1, characterized in that the first current source (10) comprises a first NMOS transistor (M3) and the second current source (20) comprises a first PMOS transistor (M4), the gates of both transistors being connected to control means for controlling the conductivity of both transistors to the same extent.

3. An output driver circuit as claimed in Claim 1,
characterized in that the first acceleration circuit (12) comprises a second PMOS transistor (M92) and a first series connection which consists of a third PMOS transistor (M90) and a second NMOS transistor (M91), the second acceleration circuit (22) comprising a third NMOS transistor (M94) and a second series connection which consists of a fourth PMOS transistor (M97) and a fourth NMOS transistor (M96), the first series connection being arranged between the first node (N3) and the lower supply voltage (Vss), the gate of the third PMOS transistor (M90) being connected to the second PMOS transistor (M92) and a first input (DPU) being coupled to the gate of the second NMOS transistor (M91), the second series connection being arranged between the upper supply voltage (Vcc) and the second node (N4), the gate of the fourth NMOS transistor (M96) being connected to the third NMOS transistor (M94) and a second input (DPD) being coupled to the gate of the fourth PMOS transistor (M97), and in that the threshold voltages of the first output transistor (M1) and of the second PMOS transistor (M92) as well as of the second output transistor (M2) and of the third NMOS transistor (M94) are substantially equal.

4. An output driver circuit as claimed in Claims 3, characterized in that a fifth PMOS transistor (M6) is connected between the upper supply voltage (Vcc) and the first node (N3) and a fifth NMOS transistor (M5) is connected between the second node (N4) and the lower supply voltage (Vss), the first input (DPU) also being coupled to the gate of the fifth PMOS transistor (M6), the second input signal (DPD) also being coupled to the gate of the fifth NMOS transistor (M5).

5. An output driver circuit as claimed in Claim 2, characterized in that the first input (DPU) is coupled to the first NMOS transistor (M3) *via* a first inverter (IV2), and the second input (DPD) is coupled to the first PMOS transistor (M4) *via* a second inverter (IV4).

6. An output driver circuit as claimed in any one of the Claims 2 to 5, characterized in that the conductivity of the first NMOS transistor (M3) and the first PMOS transistor (M4) is controlled via a third input (PDWN).

7. An output driver circuit as claimed in any one of the Claims 2 to 6, characterized in that a first output of a current mirror circuit (R1, M49-M53) is connected to the gate of the first NMOS transistor (M3) and a second output of the current mirror circuit is connected to the gate of the first PMOS transistor (M4).

8. An output driver circuit as claimed in Claim 6 and 7, characterized in that when the third input signal (PDWN) is in a first logic state, the first NMOS transistor (M3) and the first PMOS transistor (M4) are saturated, and that when the third input signal (PDWN) is in a second logic state, the conductivity of the first NMOS transistor (M4) and the first PMOS transistor (M4) is determined by the current mirror circuit.

## Revendications

1. Circuit d'attaque de sortie avec un premier transistor de sortie (M1) entre une première tension d'alimentation supérieure (Vcc) et un noeud de sortie (N1), un deuxième transistor de sortie (M2) entre le noeud de sortie (N1) et une tension d'alimentation inférieure (Vss), un premier condensateur (C1) entre la grille du premier transistor de sortie (M1) et le noeud de sortie (N1), un deuxième condensateur (C2) entre le noeud de sortie (N1) et la grille du deuxième transistor de sortie (M2), une première source de courant (10) qui est reliée au premier condensateur (C2) et à la grille du premier transistor de sortie dans un premier point d'accouplement (N3) pour délivrer un premier courant vers le premier point d'accouplement (N3), une deuxième source de courant (20) qui est reliée au deuxième condensateur C1 et à la grille du deuxième transistor de sortie (M2) dans un deuxième point d'accouplement (N4) en vue de délivrer un deuxième courant au deuxième point d'accouplement (N4), caractérisé en ce qu'un premier circuit d'accélération (12) dont l'entrée et la sortie sont couplées au premier point d'accouplement (N3) et un deuxième circuit d'accélération (22) dont l'entrée et la sortie sont couplées au deuxième point d'accouplement (N4) sont commandés de telle sorte que, lorsque la tension-seuil des transistors de sortie (M1, M2) est atteinte, ils mettent délibérément hors circuit un courant produit par les circuits d'accélération qui est nettement plus élevé que le premier ou deuxième courant, en vue de la charge plus rapide des condensateurs (C1, C2) lors de la mise sous tension des transistors de sortie (M1, M2) par un commutateur respectif de valeurs-seuils (16, 26) qui a essentiellement la même tension-seuil que le transistor de sortie correspondant.

2. Circuit d'attaque de sortie selon la revendication 1,
caractérisé en ce que la première source de courant contient un premier transistor NMOS (M3) et la deuxième source de courant un premier transistor PMOS (M4), les grilles des deux transistors étant reliées à des moyens de commande en vue de la commande de la conductibilité des deux transistors dans une même proportion.

3. Circuit d'attaque de sortie selon la revendication 1,
caractérisé en ce que le premier circuit d'accélération (12) contient un deuxième PMOS (M92) et un premier montage en série composé d'un troisième transistor PMOS (M90) et d'un deuxième transistor NMOS (M91) et le deuxième circuit d'accélération (22) contient un troisième transistor NMOS (M94) et un deuxième montange en série composé d'un quatrième transistor PMOS (M97) et d'un quatrième transistor NMOS (M96), que le premier montage en série est disposé entre le premier point d'accouplement (N3) et la source d'alimentation inférieure (Vss), la grille du troisième transistor PMOS (M90) étant reliée au deuxième transistor PMOS (M92) et une première entrée (DPU) étant couplée à la grille du deuxième transistor NMOS (M91), que le deuxième montage en série est disposé entre la tension d'alimentation supérieure (Vcc) et le deuxième point d'accouplement (N4), la grille du quatrième transistor NMOS (M96) étant reliée au troisième transistor NMOS (M94) et une deuxième entrée (DPD) étant couplée à la grille du quatrième transistor PMOS (M97) et que les tensions-seuils du premier transistor de sortie (M2) et du troisième transistor NMOS (M94) sont essentiellement égales.

4. Circuit d'attaque de sortie selon la revendication 3,
caractérisé en ce qu'un cinquième transistor PMOS (M6) est monté entre la tension d'alimentation supérieure (Vcc) et le premier point d'accouplement (N3) et un cinquième transistor NMOS (M5) est monté entre le deuxième point d'accouplement (N4) et la tension d'alimentation inférieure (Vss), que la première entrée (DPU) est par ailleurs couplée à la grille du cinquième transistor PMOS (M6) et la deuxième entrée (DPD) est par ailleurs couplée à la grille du cinquième transistor NMOS (M5).

5. Circuit d'attaque de sortie selon l'une des revendications 2 et 3,
caractérisé en ce que la première entrée (DPU) est couplée par l'intermédiaire d'un premier inverseur (IV2) au premier transistor NMOS (M3) et le deuxième signal d'entrée (DPD) est couplé par l'intermédiaire d'un deuxième inverseur (IV4) au premier transistor PMOS (M4).

6. Circuit d'attaque de sortie selon l'une des revendications 2 à 5,
caractérisé en ce que la conductibilité du premier transistor NMOS (M3) et du premier transistor PMOS (M4) peut être commandée par l'intermédiaire d'une troisième entrée (PDWN).

7. Circuit d'attaque de sortie selon l'une des revendications 2 à 6,
caractérisé en ce qu'une première sortie d'un circuit de courant-image (R1, M49 - M53) est reliée à la grille du premier transistor NMOS (M3) et une deuxième sortie du circuit d'inversion du courant est reliée à la grille du premier transistor PMOS (M4).

8. Circuit d'attaque de sortie selon l'une des revendications 6 ou 7,
caractérisé en ce que, lorsque le troisième signal d'entrée (PDWN) se trouve dans un premier état logique, le premier transistor (M3) et le premier transistor PMOS (M4) deviennent saturés et, lorsque le troisième signal d'entrée (PDWN) se trouve dans un deuxième état logique, la conductibilité du premier NMOS (M3) et du premier PMOS (M4) est déterminée par le circuit de courant-image.
